# EUROPEAN PATENT APPLICATION

(11) **EP 4 848 968 A1**
(43) Date of publication of application: **02.12.2026**
(21) Application number: 25224272.2
(22) Date of filing: 17.12.2025
(51) Int. Cl.: H10W 20/20

(54) **COMPLEMENTARY FIELD-EFFECT TRANSISTOR FORMATION TECHNIQUES USING HYBRID BONDING**

(30) Priority: 30.05.2025 US 202519223851
(71) Applicant: Intel Corporation, Santa Clara, CA 95054 (US)
(72) Inventor: KOBRINSKY, Mauro J., Portland, 97229 (US); MANNEBACH, Ehren, Beaverton, 97007 (US); MILLS, Shaun, Hillsboro, 97124 (US); D'SILVA, Joseph, Hillsboro, 97124 (US); VYATSKIKH, Andrey, Hillsboro, 97123 (US)
(74) Representative: 2SPL Patentanwälte PartG mbB

(57) **Abstract**

Complementary field-effect transistor (CFET) formation techniques using hybrid bonding are described herein. In one example, N-type and P-type transistors may be formed on separate wafers, and one or more interconnect layers may be formed over each of the separate wafers. A wafer or die including one type of transistor may then be bonded with a wafer including the other type of transistor. For example, the wafers may be bonded face-to-face such that the interconnect layers of those wafers are bonded together, or one of the wafers may first be diced and dies may be bonded face-to-face with the other wafer. Once bonded, the conductive lines and/or vias of the interconnect layers between the two devices (e.g., between an N-type transistor and a P-type transistor) provide interconnection(s) between terminal(s) of the devices.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIG. 2 is a top-down view of an IC structure including nanoribbon-based transistors and deep trench vias, according to one embodiment of the present disclosure.
FIGS. 3A-3C are cross-sectional side views along different cross-sections of the IC structure of FIG. 2, according to some embodiments of the present disclosure.
FIG. 4 is a flow diagram of an example method for fabricating an IC structure including CFETs using hybrid bonding, according to some embodiments of the present disclosure.
FIGS. 5, 6, and 7A-7C provide different views at various stages in the fabrication of an example IC structure according to the method of FIG. 4, in accordance with some embodiments.
FIG. 8 illustrates a diagram showing a process involving hybrid-bonding dies to a wafer, in accordance with some embodiments.
FIG. 9 is a top view of a wafer and dies that may include any of the IC structures disclosed herein, in accordance with any of the embodiments disclosed herein.
FIG. 10 is a side, cross-sectional view of an IC device that may include any of the IC structures disclosed herein, in accordance with any of the embodiments disclosed herein.
FIG. 11 is a side, cross-sectional view of an IC package that may include any of the IC structures disclosed herein, in accordance with various embodiments.
FIG. 12 is a side, cross-sectional view of an IC device assembly that may include any of the IC structures disclosed herein, in accordance with any of the embodiments disclosed herein.
FIG. 13 is a block diagram of an example electrical device that may include any of the IC structures disclosed herein, in accordance with any of the embodiments disclosed herein.

### Detailed Description

Disclosed herein are integrated circuit (IC) structures and complementary field-effect transistor (CFET) formation techniques using hybrid bonding. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

IC structures may include transistors that can classify as N-type (e.g., N-type FET (NFET) or N-type metal-oxide-semiconductor (NMOS) transistors) and/or P-type (e.g., P-type FET (PFET) or P-type metal-oxide-semiconductor (PMOS) transistors) based on the type of charge carriers that conduct current in the transistor channel. An N-type transistor (e.g., NFET or NMOS) operates using electrons as the primary charge carriers within an N-type semiconductor channel. Both the source and drain regions are N-doped (i.e., doped with N-type dopants), meaning they contain an excess of electrons. N-type dopants are dopants deliberately added to a semiconductor material (e.g., to S/D regions of an N-type transistor) to introduce additional electrons into the crystal lattice, and that these dopants are also known as "donor" impurities. An N-type transistor turns ON when a positive voltage is applied to the gate, creating an electric field that attracts electrons into the channel, allowing current to flow. Conversely, when the gate voltage is low or zero, the channel remains non-conductive, keeping the transistor in the OFF state.

A P-type transistor (e.g., PFET or PMOS) operates using holes as the primary charge carriers within a P-type semiconductor channel. The source and drain regions are P-doped (i.e., doped with P-type dopants), meaning they contain an excess of holes. P-type dopants are dopants deliberately added to a semiconductor material (e.g., to S/D regions of a P-type transistor) to introduce additional holes into the crystal lattice, and that these dopants are also known as "acceptor" impurities. A P-type transistor turns ON when a negative voltage is applied to the gate, creating an electric field that attracts holes into the channel, allowing current to flow. Conversely, when the gate voltage is high or zero, the channel remains non-conductive, keeping the transistor in the OFF state.

Complementary Metal-Oxide-Semiconductor (CMOS) technology uses both N-type and P-type transistors to build efficient logic circuits. For example, a basic CMOS inverter requires one N-type and one P-type transistor with connected gates. A CFET refers to a device with an N-type transistor and a P-type transistor. One technique for forming a monolithic CFET involves patterning a stack that includes a channel material for an N-type transistor, a gate stack, and a channel material for a P-type transistor. In one such example, the N-type and P-type transistors are self-aligned due to patterning the stack including the N-type and P-type channel materials with the same processes. However, the etch processes used for such a technique may be prohibitively challenging due to the high aspect ratios of trenches formed in the stack.

Another technique for forming CFET devices, which may be referred to as a sequential CFET, involves forming one type of transistor (e.g., either NMOS or PMOS) on a wafer, providing an additional layer of semiconductor material over the wafer using a layer transfer process, and forming another type of transistor in the layer-transferred semiconductor material. Such a technique may not suffer from etching challenges to the same extent as the monolithic CFET technique mentioned above (e.g., due to forming the NMOS and PMOS transistors sequentially with separate processes); however, this technique faces different challenges related to temperature constraints. For example, when forming transistors in the layer-transferred material, excessively high temperatures may damage the transistors formed previously on the wafer.

In contrast, CFET formation techniques using hybrid bonding may enable stacked transistors (such as a CFET including an N-type transistor and a P-type transistor stacked over one another) without the process constraints and challenges of other device-stacking techniques. In one example, N-type and P-type transistors may be formed on separate wafers, and one or more interconnect layers may be formed over each of the separate wafers. A wafer or die including one type of transistor may then be bonded with a wafer including the other type of transistor. For example, the wafers may be bonded face-to-face such that the interconnect layers of those wafers are bonded together, or one of the wafers may first be diced and dies may be bonded face-to-face with the other wafer. Once bonded, the conductive lines and/or vias of the interconnect layers between the two devices (e.g., between an N-type transistor and a P-type transistor) provide interconnection(s) between terminal(s) of the devices. For example, the conductive lines and/or vias of the interconnect layers between an N-type transistor and a P-type transistor may couple the drain regions together and/or gate regions together.

IC structures as described herein, in particular IC structures including CFETs fabricated using hybrid bonding as described herein, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures including CFETs fabricated using hybrid bonding as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices (e.g., physically coupled, conductively coupled, e.g., directly electrically connected). A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

IC structures including CFETs fabricated using hybrid bonding may include transistors of any architecture (e.g., any planar and/or non-planar transistor architecture). Non-planar transistors such as double-gate transistors, trigate transistors, FinFETs, nanowire, and nanoribbon transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

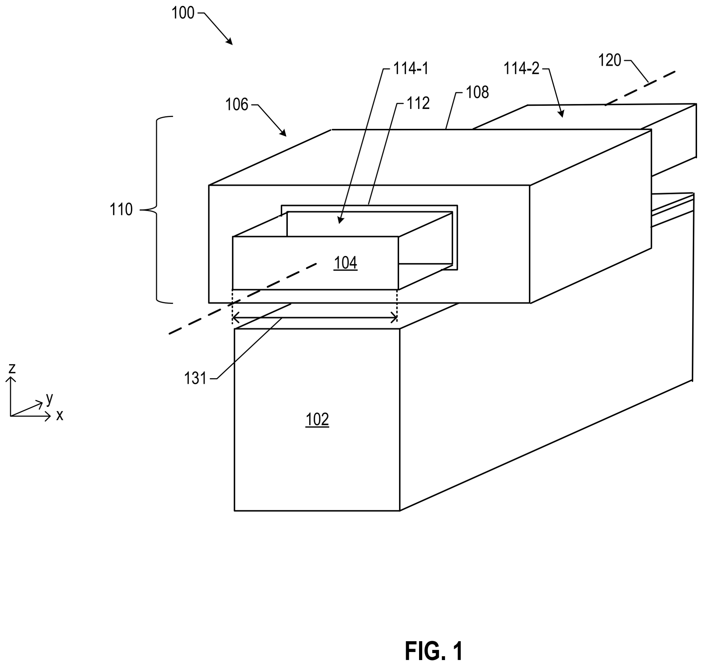

Nanoribbon transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors). Therefore, some IC structures illustrated herein show nanoribbon transistors as an example (e.g., IC structures shown in FIG. 1, 2, and 3A-3C), although IC structures including CFETs fabricated using hybrid bonding as described herein may include other devices instead of or in addition to nanoribbon-based transistors, and are not limited to such transistors.

As used herein, the term "nanoribbon" refers to an elongated semiconductor structure having a long axis parallel to a support structure (e.g., a substrate, a chip, or a wafer) over which a transistor arrangement is provided. In some settings, the term "nanoribbon" has been used to describe an elongated semiconductor structure that has a rectangular transverse cross-section (i.e., a cross-section in a plane perpendicular to the longitudinal axis of the structure), while the term "nanowire" has been used to describe a similar structure but with a circular or square-like transverse cross-section. In the present disclosure, the term "nanoribbon" is used to describe both such nanoribbons (including nanosheets) and nanowires, as well as elongated semiconductor structures with a longitudinal axis parallel to the support structures and with having transverse cross-sections of any geometry (e.g., oval, or a polygon with rounded corners). As used herein, the term "face of a nanoribbon" refers to any of the confinement surfaces (i.e., interfaces of the semiconductor material of the nanoribbon with the gate stack) of the nanoribbon which are substantially parallel to the support structure when a nanoribbon extends in a direction parallel to the support structure, while the term "sidewall of a nanoribbon" refers to any of the confinement surfaces of the nanoribbon connecting the bottom face and the top face (the bottom face being the face of the nanoribbon that is closer to the support structure than the top face).

Another example of a nanoribbon-based transistor architecture is a nanocomb transistor architecture (also sometimes referred to as a forksheet architecture or SpineFET), where the name "nanocomb/forksheet" arises because of its complex bilateral finned structure. In an example nanocomb transistor arrangement, the nanoribbons are coupled with a dielectric "spine" or wall, and there is no gate enclosure on one of the two sides of the vertical stack of lateral nanoribbons or nanosheets (referred to in the following as "nanoribbons"), while the gate enclosure on the other side still remains. In other examples, a nanocomb transistor arrangement may include a portion of the gate electrode material and/or gate insulator between the dielectric spine and the nanoribbons.

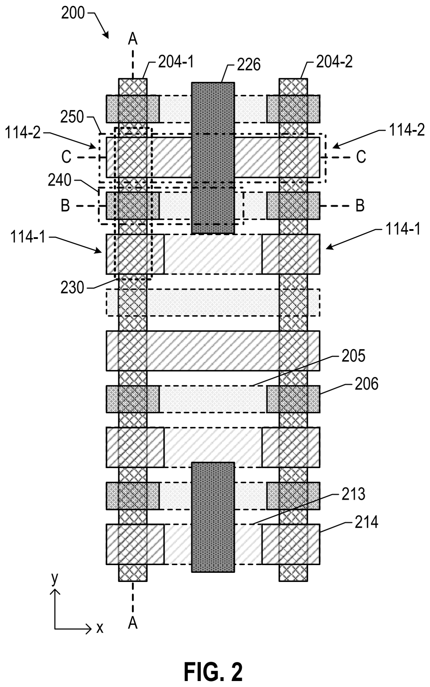

Thus, in some examples, one or both of the N-type transistor and P-type transistor may be nanoribbon-based transistors. FIGS. 1, 2, and 3A-3C illustrate examples of IC structures that include a nanoribbon-based transistor. FIG. 1 provides a perspective view of an example IC structure 100 with a nanoribbon transistor 110, according to some embodiments of the present disclosure. For example, in various embodiments, the transistor 110 formed on the basis of a nanoribbon 104, shown in FIG. 1, may be formed on the basis of any of the nanoribbon-based transistor arrangements shown in any of FIGS. 2, 3A-3C, 5, 6, and 7A-7C. In some of those examples, the nanoribbon-based transistor arrangement is a nanocomb transistor that is formed in the stacks of lateral nanoribbons separated by a dielectric wall. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2 on either side of the gate stack 106. One of the S/D regions 114-1, 114-2 is a source region and the other one is a drain region. However, because, as is common in the field of FETs, designations of source and drain are often interchangeable, they are simply referred to herein as a first S/D region 114-1 and a second S/D region 114-2.

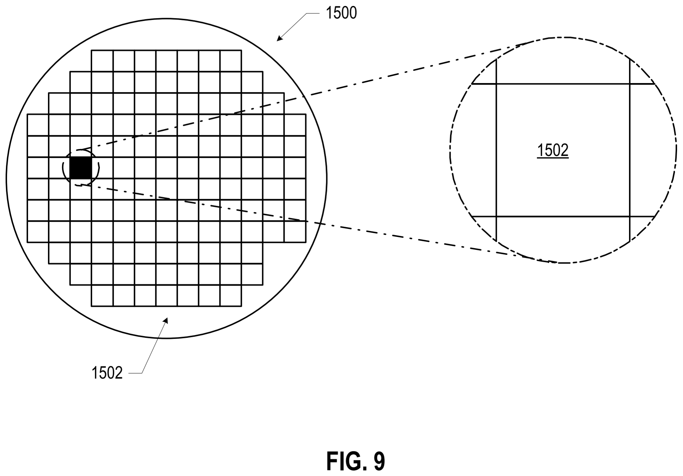

Implementations of the present disclosure may be formed or carried out on any suitable support 102, such as a substrate, a die, a wafer, or a chip. The support 102 may, e.g., be the wafer 1500 of FIG. 9, discussed below, and may be, or be included in, a die, e.g., the singulated die 1502 of FIG. 9, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure including CFETs fabricated using hybrid bonding as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIGS. 2, 3A-3C, 5, 6, and 7A-7C show IC structures that may be or include examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width 131 of the nanoribbon 104 (i.e., a dimension measured in a plane parallel to the support 102 and in a direction perpendicular to the longitudinal axis 120 of the nanoribbon 104, e.g., along the x-axis of the coordinate system) may be at least about 3 times larger than a height or thickness of the nanoribbon 104 (i.e., a dimension measured in a plane perpendicular to the support 102, e.g., along the z-axis of the coordinate system), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa_{1- x}As fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some examples, nanoribbons of the same semiconductor material may be used to form NMOS and PMOS transistors. In such examples, the NMOS and PMOS transistors may be differentiated by depositing N-type or P-type work function metals around channel portions of those transistors.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., frontend components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and PMOS transistor include gate electrode materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided below.

Turning to the S/D regions 114-1, 114-2 of the transistor 110, if the transistor 110 is an N-type transistor, the S/D regions 114-1, 114-2 may be doped with N-type dopants to create regions with an excess of electrons that can serve as the majority charge carriers during operation of the transistor 110. In an N-type transistor the channel region may be lightly doped with N-type dopants or may be an undoped/intrinsic semiconductor material. If the transistor 110 is a P-type transistor, the S/D regions 114-1, 114-2 may be doped with P-type dopants to create regions with an excess of holes that can serve as the majority charge carriers during operation of the transistor 110. In a P-type transistor the channel region may be lightly doped with P-type dopants or may be an undoped/intrinsic semiconductor material. For both N-type and P-type transistors, in some embodiments, the S/D regions may be doped with dopant concentrations of at least 10¹⁷ dopants per cubic cm (cm⁻³), or more, e.g., with dopant concentrations of at least 10¹⁸ cm⁻³ or with dopant concentrations of at least 10²⁰ cm⁻³. In some embodiments, the S/D regions 114-1, 114-2 may be heavily doped, e.g., with dopant concentrations of at least about 10²⁰ or at least about 10²¹ cm⁻³, in order to advantageously form Ohmic contacts with the respective S/D contacts, although these regions may also have lower dopant concentrations and may form Schottky contacts in some implementations. Irrespective of the exact doping levels, the S/D regions 114-1, 114-2 may be the regions having dopant concentration higher than in other regions of the transistor 110, e.g., higher than a dopant concentration in the channel region (e.g., in a portion of the channel material extending between the first S/D region 114-1 and the second S/D region 114-2). Therefore, the S/D regions 114-1, 114-2 may be referred to as "highly doped" (HD) regions of the transistor 110. The channel region of the transistor 110 may include semiconductor materials with doping concentrations significantly smaller than those of the S/D regions 114-1, 114-2. In some embodiments, a lightly doped channel region of the transistor 110 may have dopant concentrations between about 10¹⁴ cm⁻³ and about 10¹⁷ cm⁻³ or 0.5x10¹⁷ cm⁻³, while an undoped/intrinsic channel region of the transistor 110 may have dopant concentrations below about 10¹³ cm⁻³, e.g., below 10¹² cm⁻³.

The S/D regions 114-1, 114-2 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114-1, 114-2. An epitaxial deposition process may then be carried out to fill the recesses with material that is used to fabricate the S/D regions 114-1, 114-2. In some implementations, the S/D regions 114-1, 114-2 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114-1, 114-2 may be formed using one or more alternate semiconductor materials such as germanium or a group III-V material or alloy. And in further embodiments, one or more layers of metal and/or metal alloys may be used to form the S/D regions 114-1, 114-2. In some embodiments, a distance between the first and second S/D regions 114-1, 114-2 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114-1, 114-2 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

FIG. 2 is a top-down plan view of an example of an IC structure including nanoribbon-based transistors and deep trench vias. Some of the materials are not shown in the top-down view in order to not obscure the drawing.

As shown in FIG. 2, the IC structure 200 may include two nanoribbon stacks 204-1 and 204-2, if the transistors to be implemented in the IC structure 200 are nanoribbon transistors such as the one illustrated in FIG. 1. Alternatively, what is now shown as nanoribbon stacks 204-1 and 204-2 could be fins, if the transistors to be implemented in the IC structure 200 are FinFETs. The nanoribbon stacks 204-1, 204-2 may include stacks of one or more nanoribbons 104 as described above and may be provided over a support such as the support 102 (not specifically shown in FIG. 2). The nanoribbon stacks 204-1, 204-2 may extend substantially parallel to one another, e.g., along the y-axis of the coordinate system shown in FIG. 1, consistent with the illustration of FIG. 1. Metal gate lines 205 (shown in FIG. 2 to be within dashed contours) and S/D contact lines 213 may extend substantially perpendicular to the nanoribbon stacks 204-1, 204-2 and substantially parallel to one another, e.g., along the x-axis of the coordinate system shown in FIG. 1. FIG. 2 illustrates that the metal gate lines 205 and the S/D contact lines 213 may be provided in an alternating manner. Metal gate lines 205 may be cut and removed where the deep trench vias are placed, so that gate contacts 206 effectively act as portions of the metal lines 205. In FIG. 2, portions of the metal gate lines 205 are shown with dashed contours, indicating that these are the portions where the metal gate lines 205 have been removed. The gate contacts 206 are in conductive contact with the gate stacks 106 (which are underneath the gate contacts 206 and, therefore, not seen in the view of FIG. 2) provided over channel portions of the nanoribbon stacks 204-1, 204-2, providing electrical connectivity to the gates of the nanoribbon transistors. Thus, portions of the gate contacts 206 intersecting the gate stacks 106 are in conductive contact with the gate stacks 106 and serve as gate contacts for the transistors.

Similarly, S/D contact lines 213 may be cut and removed where the deep trench vias are placed, so that S/D contacts 214 effectively act as portions of the S/D contact lines 213. In FIG. 2, portions of the S/D contact lines 213 are shown with dashed contours, indicating that these are the portion where the S/D contact lines 213 have been removed. The S/D contacts 214 are provided over S/D regions 114-1, 114-2 (which are underneath the S/D contacts 214 and, therefore, not seen in the view of FIG. 2) of the nanoribbon stacks 204-1, 204-2, providing electrical connectivity to the S/D regions 114-1, 114-2 of the nanoribbon transistors. Thus, portions of the S/D contacts 214 intersecting the S/D regions 114-1, 114-2 are in conductive contact with the S/D regions 114-1, 114-2 and serve as S/D contacts for the transistors.

FIG. 2 further illustrates that deep trench vias 226 may be provided in the vicinity of the transistors formed on the basis of the nanoribbon stacks 204-1, 204-2. Two instances of the deep trench vias 226 are shown in FIG. 2, but, in other embodiments, any other number of one or more deep trench vias 226 may be included in the IC structure 200. Similarly, while a particular arrangement of gate stacks 106, metal gate lines 205, gate contacts 206, S/D contact lines 213, and S/D contacts 214 is shown in FIG. 1 and FIG. 2, in other embodiments, these elements may be arranged differently within the IC structure 200.

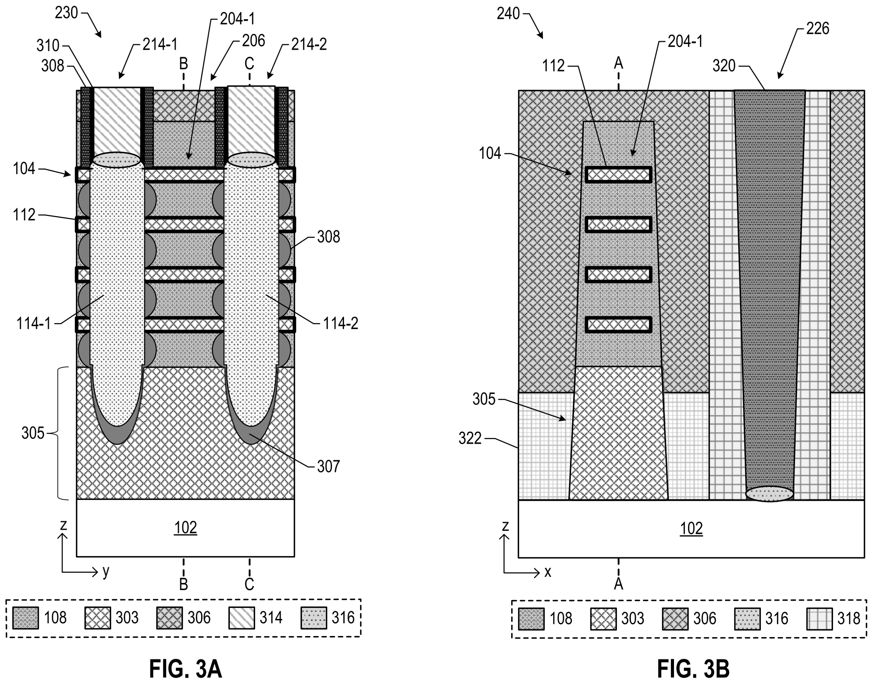

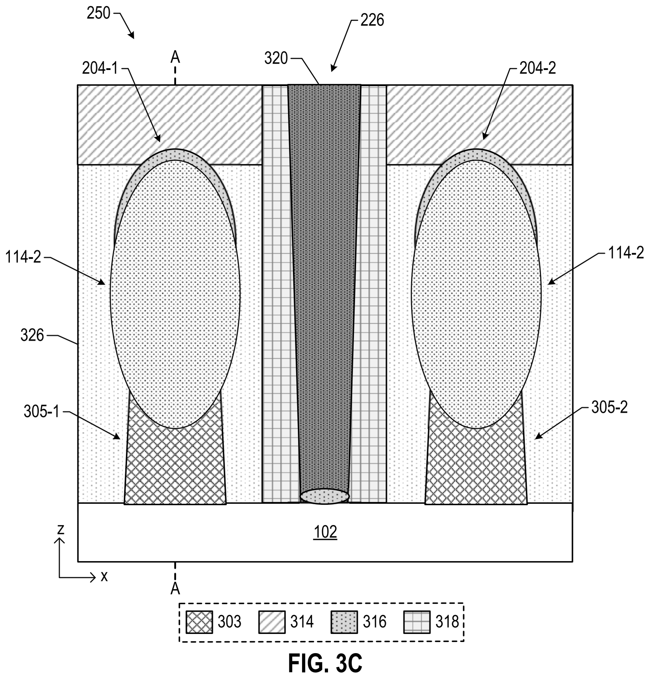

In order to further illustrate details of the IC structure 200, FIG. 2 shows a portion 230 (illustrated with a dotted contour), a portion 240 (illustrated with a dot-dashed contour), and a portion 250 (illustrated with a double-dot-dashed contour). The portion 230 indicates an approximate outline of an example transistor such as the transistor 110, provided over the nanoribbon stack 204-1. The portion 240 illustrates a portion of the IC structure 200 with a gate contact 206 provided over a gate stack 106 over a channel portion of the nanoribbon stack 204-1 and a deep trench via 226. FIGS. 3A-3C are cross-sectional side views along different cross-sections of the IC structure 200 of FIG. 2, according to some embodiments of the present disclosure. In particular, FIG. 3A illustrates a cross-sectional side view of the portion 230 along a plane AA shown in FIG. 2, FIG. 3B illustrates a cross-sectional side view of the portion 240 along a plane BB shown in FIG. 2, and FIG. 3C illustrates a cross-sectional side view of the portion 250 along a plane CC shown in FIG. 2. A number of elements referred to in the description of FIGS. 3A-3C with reference numerals are illustrated in these drawings with different patterns, with a legend showing the correspondence between the reference numerals and patterns being provided at the bottom of each drawing page containing FIGS. 3A-3C. For example, the legend illustrates that FIGS. 3A-3C use different patterns to show a gate electrode material 108, a semiconductor material 303, an electrically conductive material 306 of a gate contact 206, and so on.

As shown in FIG. 3A, the portion 230 includes a transistor similar to the transistor 110 but built on the basis of a nanoribbon stack 204-1 of a plurality of nanoribbons 104 instead of just one nanoribbon 104 as shown in FIG. 1. While four nanoribbons 104 are shown to be included in the nanoribbon stack 204-1, in other embodiments, fewer nanoribbons 104 or more nanoribbons 104 may be included. FIG. 3A illustrates a semiconductor material 303 as the material of the nanoribbons 104, further illustrating a subfin 305 of the semiconductor material 303 below the nanoribbon stack 204-1, although in some embodiments the nanoribbons 104 and at least a portion of the subfin 305 may include semiconductor materials of different material compositions. As shown in FIG. 3A, a gate stack having a gate insulator material 112 and a gate electrode material 108 may wrap around channel portions of the nanoribbons 104. FIG. 3A further illustrates a first S/D region 114-1 and a second S/D region 114-2 extending through the nanoribbon stack 204-1, electrically insulated/separated from the gate electrode material 108 and from the semiconductor material 303 of the subfin 305 by an insulator material 307. In some embodiments, the insulator material 307 may form so-called "dimples" 308 in areas where the insulator material 307 separates the S/D regions 114-1, 114-2 from the gate electrode material 108. The insulator material 307 may include any of the insulator materials described herein, e.g., any of the ILD materials described above.

Above the nanoribbon stack 204-1, FIG. 3A illustrates a gate contact 206 and S/D contacts 214 on either side of the gate contact 206, individually labeled as a first S/D contact 214-1 for making electrical contact to the first S/D region 114-1 and a second S/D contact 214-2 for making electrical contact to the second S/D region 114-2. The gate contact 206 may include an electrically conductive material 306 in electrically conductive contact with the gate electrode material 108. In various embodiments, material compositions of the electrically conductive material 306 and the gate electrode material 108 may be substantially the same or different.

The S/D contacts 214 may be electrically isolated from the gate electrode material 108 and the electrically conductive material 306 of the gate contact 206 by gate spacers 308. The gate spacers 308 may include one or more of spacer materials, diffusion barrier materials, adhesion materials, etc., as known in the art for forming contacts to various components of IC structures. In some embodiments, the gate spacers 308 may include low-k dielectrics and/or any of the ILD materials described above. Optionally, sidewalls of the S/D contacts 214 may be lined with one or more liners 310, where the liners 310 may include, but not limited to, materials comprising silicon and nitrogen (e.g., silicon nitride), materials comprising silicon and oxygen (e.g., silicon oxide), materials comprising silicon and carbon (e.g., silicon carbide), and/or their composites. Within the sidewalls, the S/D contacts 214 may be filled with an electrically conductive fill material 314. In various embodiments, material compositions of the electrically conductive fill material 314 and the electrically conductive material 306 may be substantially the same (e.g., both may include/be tungsten) or different. At the bottom of the S/D contacts 214, an interface material 316 is deposited to provide an interface between the S/D regions 114-1, 114-2 and the electrically conductive fill material 314 of S/D contacts 214. The interface material 316 may include/be a metal such as titanium which, once deposited, may intermix with the material of the S/D regions 114-1, 114-2, e.g., with silicon, forming a compound (e.g., titanium silicide) that may help reduce contact resistance of the S/D contacts 214. Although FIG. 3A illustrates an example in which the interface material 316 is only present on the bottom of the S/D contacts 214 and not the sidewalls of the S/D contacts 214, in other examples the interface material 316 may be present on the bottom and sidewalls of the S/D contacts 214. In other embodiments, the interface material 316 is optional and may be absent from the bottom and/or absent from the side walls of the S/D contacts 214.

FIG. 3B shows a cross-sectional side view of the IC structure 200 along the plane BB shown in FIG. 2 and in FIG. 3A (i.e., a gate cut). FIG. 3C shows the plane AA along which the cut of FIG. 3A is shown. Turning to FIG. 3B, the portion 240 illustrates a deep trench via 226, an insulator material 318 surrounding the deep trench via 226, an electrically conductive via fill material 320 filling the deep trench via 226, and an insulator material 322 surrounding sidewalls of the subfin 305. The insulator material 318 and the insulator material 322 may, e.g., include any of the ILD materials described above and may have either substantially the same or different material compositions. The insulator material 322 may sometimes be referred to as a "shallow-trench insulator" (STI). The insulator material 322 is provided to electrically isolate the deep trench via 226 from the adjacent electrically conductive structures and materials, e.g., to electrically isolate the deep trench via 226 from the electrically conductive material 306 of the gate contact 206, which may extend along any of the metal gate lines 205. The electrically conductive via fill material 320 filling the deep trench via 226 may include any suitable conductive material, e.g., tungsten, and may have substantially the same or different material composition with the electrically conductive material 306 of the gate contact 206 and/or with the electrically conductive fill material 314 of the S/D contacts 214.

FIG. 3C provides another helpful illustration of the IC structure 200 along the plane CC shown in FIG. 2 and in FIG. 3A (i.e., a cut across S/D regions of two different nanoribbon stacks 204-1, 204-2). FIG. 3C shows the plane AA along which the cut of FIG. 3A is shown.

FIG. 3C illustrates the deep trench via 226, an insulator material 318 surrounding the deep trench via 226 as shown in FIG. 3B, and two S/D regions 114-2, one on each side of the deep trench via 226 and electrically insulated from the deep trench via 226 by the insulator material 318. The two S/D regions 114-2 are provided over different ones of the nanoribbon stacks 204-1 and 204-2, as shown in FIG. 2 and FIG. 3C. FIG. 3C further illustrates an insulator material 326 that may surround the S/D regions 114-2 below the electrically conductive fill material 314 of the S/D contacts 214, and may also surround the sidewalls of the subfins 305-1 and 305-2 of the nanoribbon stacks 204-1 and 204-2. The insulator material 326 may, e.g., include any of the ILD materials described above and may have either substantially the same or different material compositions with any other insulator materials in the IC structure 200, e.g., with the insulator material 322 shown in FIG. 3B. FIG. 3C shows the interface material 316 onto the S/D regions 114-2 and at the bottom of the deep trench via 226, however, as mentioned above, an interface may be present or absent at one or more of: the bottom and/or sidewalls of the deep trench via 226 and the bottom and/or sidewalls of openings for the S/D contacts 214.

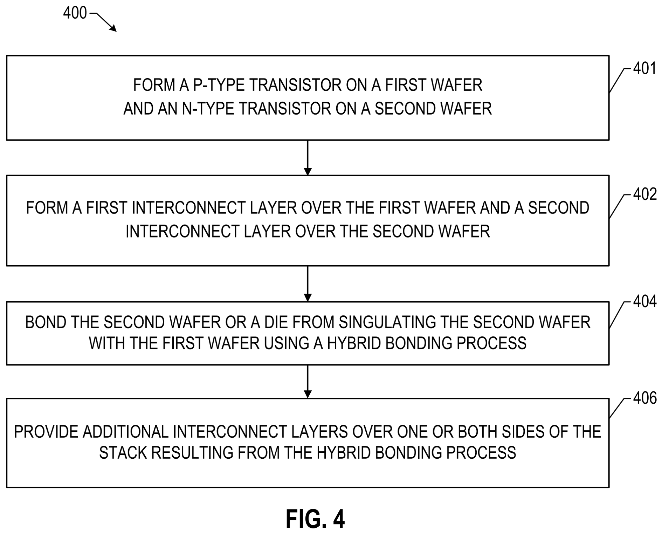

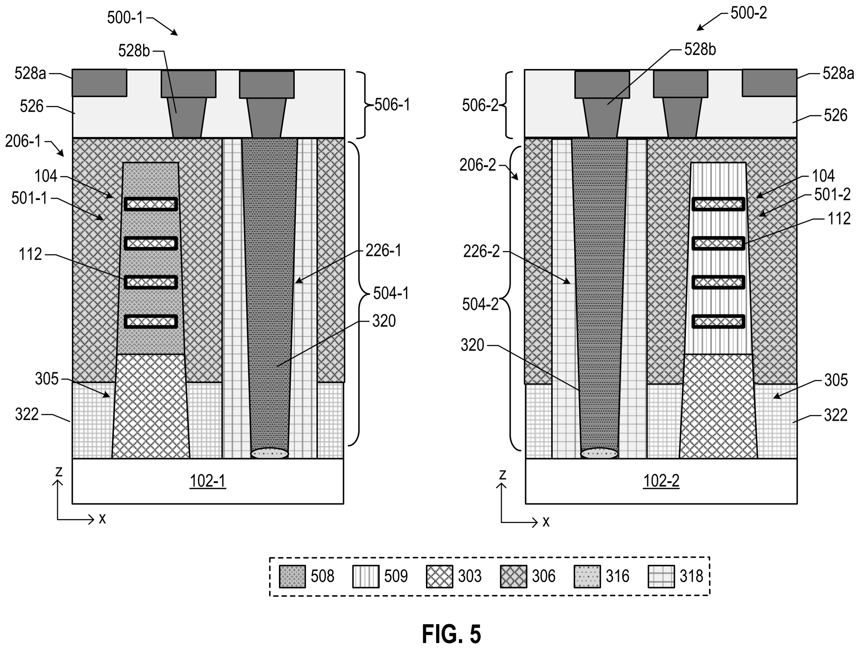

FIG. 4 is a flow diagram of an example method 400 for fabricating an IC structure including CFETs fabricated using hybrid bonding. FIGS. 5, 6, and 7A-7C provide different views at various stages in the fabrication of an example IC structure according to the method of FIG. 4, in accordance with some embodiments. Although the operations of the method of FIG. 4 are illustrated once each and in a particular order, the operations may be performed in any suitable order and repeated as desired. For example, one or more operations may be performed in parallel to fabricate multiple IC structures using hybrid bonding substantially simultaneously. In another example, the operations may be performed in a different order to reflect the structure in which a CFET fabricated using hybrid bonding will be implemented.

In addition, the example fabricating method of FIG. 4 may include other operations not specifically shown in FIG. 4, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 4 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Turning to FIG. 4, the method 400 begins with a process 401 of forming a P-type transistor on a first wafer and forming an N-type transistor on a second wafer. The processes used to form N-type and P-type transistors depend on the transistor architecture and may generally involve forming source and drain regions and a gate stack coupled with a channel region. In one example in which the transistors are nanoribbon-based transistors, the process of forming transistors may involve patterning a stack of alternate layers of a semiconductor material and a sacrificial material (e.g., a different semiconductor material) into fins, forming S/D openings in a fin on either side of a channel portion of the fin, providing a doped semiconductor material in the S/D openings, removing the sacrificial material to release nanoribbons of the semiconductor material, providing a gate dielectric material around channel portions of the nanoribbons, providing a gate electrode material around the channel portions of the nanoribbons, and forming gate and S/D contact structures coupled with the gate electrode material and S/D regions, respectively.

The method 400 continues with a process 402 of forming a first interconnect layer over a first side (e.g., front side) of the first wafer and a second interconnect layer over a first side (e.g., a front side) of the second wafer. Forming interconnect layers over a wafer may involve depositing a dielectric material, patterning the dielectric material with trench and via openings using photolithography techniques, and filling the openings with a conductive material such as copper (e.g., using techniques such as electroplating or chemical vapor deposition (CVD)).

The IC structures 500-1 and 500-2 of FIG. 5 are examples of IC structures resulting from the processes 401 and 402. The IC structures 500-1 and 500-2 may represent two wafers, or a wafer and a die. In the example illustrated in FIG. 5, the IC structures 500-1 and 500-2 each include a device region and an interconnect layer over the device region. For example, the IC structure 500-1 includes an interconnect layer 506-1 formed above the device region 504-1, and the IC structure 500-2 includes an interconnect layer 506-2 formed over the device region 504-2. In some examples, the interconnect layers 506-1, 506-2 may represent metal 0 (M0) layers. In other examples, the interconnect layer formed over the device regions 504-1, 504-2 may represent a layer with interconnects (such as vias) between the transistor contacts and M0. Additional interconnect layers may be present above the interconnect layers 506-1, 506-2. A collection of interconnect layers such as the interconnect layer 506-1 may be referred to as a "metallization stack" of the IC structure. Interchangeably, interconnect layers 506-1, 506-2 may be referred to as the "back end of line (BEOL) layer(s)" of the IC structures, while the device regions 504-1, 504-2 may be referred to as the "front end of line (FEOL) layer(s)" of the IC structures. A FEOL layer refers to a layer formed in the FEOL, such as a device layer or device region. In the FEOL, individual semiconductor devices components (e.g., transistors, capacitors, resistors, etc.) can be patterned in a wafer.

In the example illustrated in FIG. 5, the FEOL layers each include a device region 504-1, 504-2 over a substrate 102-1, 102-2. The substrates 102-1, 102-2 may be semiconductor substrates composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline.

The device regions 504-1, 504-2 include devices. The devices may be frontend devices (e.g., frontend transistors such as FinFETs, nanowire/nanoribbon transistors, frontend memory cells, and/or other frontend devices). In the example illustrated in FIG. 5, the device regions 504-1, 504-2 include transistors 501-1 and 501-2, which may be examples of the transistors described in FIGS. 2 and 3A-3C. Transistors 501-1 and 501-2 may be the same or different in various aspects to optimize their functionality within the integrated circuit structure. For instance, the transistors may differ in doping types, with transistor 501-1 including N-type dopants and transistor 501-2 including P-type dopants, enabling complementary operation when they are coupled together with a subsequent hybrid bonding process. For example, transistor 501-1 may include a first region that is either a source region or a drain region, while transistor 501-2 may include a second region that is either a source region or a drain region, with one of the regions including P-type dopants and the other including N-type dopants.

Their channel regions may have substantially the same widths or may vary in width, allowing for tailored electrical characteristics suited to specific design requirements. For example, transistor 501-1 may include a first channel region with a first width, while transistor 501-2 may include a second channel region with a second width, where the first width may be different from the second width. In some examples where the channel widths are different, one of the transistors may have a channel width that is about 10-100% greater than the other transistor channel width, or about 10-200% greater than the other transistor channel width.

Additionally, the channel materials may differ. For example, transistor 501-1 may include a channel material such as silicon and the transistor 501-2 may include a channel material such as gallium nitride or a two-dimensional (2D) material (e.g., a transition metal dichalcogenide or other 2D material). For example, transistor 501-1 may include a first channel region including a first channel material, while transistor 501-2 may include a second channel region including a second channel material, where the first channel material is different from the second channel material.

The crystal orientation of the channel materials may be substantially the same or different. For example, transistor 501-1 may include a first channel region including a first channel material, while transistor 501-2 may include a second channel region including a second channel material, where the first channel material has a different crystal orientation relative to the second channel material.

Furthermore, the transistors may feature distinct architectures, such as a nanoribbon-based transistor architecture for one transistor 501-1 and a nanocomb transistor architecture or finFET architecture for transistor 501-2, etc., offering flexibility in design and integration. For example, transistor 501-1 may include a first channel region and a first gate structure coupled with the first channel region, while transistor 501-2 may include a second channel region and a second gate structure coupled with the second channel region, where the first gate structure has a different geometry from the second gate structure in a cross-section through the channel regions and source or drain regions (where the geometry of the gate structure refers to the shape and/or relative arrangement of the gate structure relative to the channel region).

In the example illustrated in FIG. 5, the transistors 501-1 and 501-2 are both nanoribbon-based transistors, where the transistor 501-1 is an N-type transistor with an N-type work function metal for the gate electrode material 508 and the transistor 501-2 is a P-type transistor with a P-type work function metal for the gate electrode material 509.

In the BEOL, interconnect structures such as conductive lines and conductive vias, separated as needed by an insulator material, can be formed to interconnect individual components. The BEOL usually starts with forming the first metal layer on the wafer. The first metal layer is often called M0. Additional metal layers can be formed on top of M0, and these metal layers are often called M1, M2, and so on. Thus, the interconnect layers 506-1 and 506-2 may represent M0 layers.

Electrical signals, such as power and/or input/output (I/O) signals, may be routed to and/or from the devices (e.g., the transistors) of the device regions 504-1, 504-2 through one or more interconnect layers disposed over the device regions 504-1, 504-2 (illustrated in FIG. 5 as interconnect layers 506-1, 506-2). For example, electrically conductive features of the device regions 504-1, 504-2 (e.g., the electrically conductive material 306 of the gate contacts 206-1, 206-2 and the electrically conductive via fill material 320 of the deep trench vias 226-1, 226-2) may be electrically coupled with the interconnect structures of the interconnect layers 506-1, 506-2. The interconnect structures may be arranged within the interconnect layers of the metallization stack to route electrical signals according to a wide variety of designs (in particular, the arrangement is not limited to the particular configuration of interconnect structures depicted in FIG. 5).

In some embodiments, the interconnect structures may include conductive lines 528a and/or conductive vias 528b filled with an electrically conductive material such as a metal. The lines 528a may be arranged to route electrical signals in a direction of a plane that is substantially parallel with a surface of the substrates 102-1, 102-2 upon which the device regions 504-1, 504-2 are formed. For example, the lines 528a may route electrical signals in a direction in and out of the page from the perspective of FIG. 5. The vias 528b may be arranged to route electrical signals in a direction of a plane that is substantially perpendicular to the surface of the substrates 102-1, 102-2 upon which the device regions 504-1, 504-2 are formed. In some embodiments, the vias 528b may electrically couple lines 528a of different interconnect layers of a metallization stack together.

The interconnect layers 506-1, 506-2 may include a dielectric material 526 disposed between the interconnect structures, as shown in FIG. 5. In some embodiments, the dielectric material 526 disposed between the interconnect structures in the interconnect layers 506-1 and 506-2 may have different compositions; in other embodiments, the composition of the dielectric material 526 in the interconnect layers 506-1, 506-2 may be the same.

Although only one interconnect layer 506-1, 506-2 is depicted over each device region 504-1, 504-2 in FIG. 5, as mentioned above, additional interconnect layers, as desired, may be formed in succession on the interconnect layers 506-1, 506-2 according to similar techniques and configurations described in connection with the second interconnect layers 506-1, 506-2. Additionally, the IC structures 500-1 and 500-2 may include the same number of interconnect layers, or may have a different number of interconnect layers. For example, one of the IC structures 500-1, 500-2 may have an M0 layer, and the other one of the IC structures 500-1, 500-2 may include a layer below M0 that includes conductive vias coupled with transistor contacts. In another example, one of the IC structures 500-1, 500-2 may include an M0 layer and an M1 layer, and another of the IC structures 500-1, 500-2 may include an M0 layer and a layer with vias between M0 and M1. In other examples, the IC structures 500-1, 500-2 may include the same the interconnect layers (e.g., both the IC structures 500-1, 500-2 may include M0 only, or both the IC structures 500-1, 500-2 may include M0 and M1, and so forth).

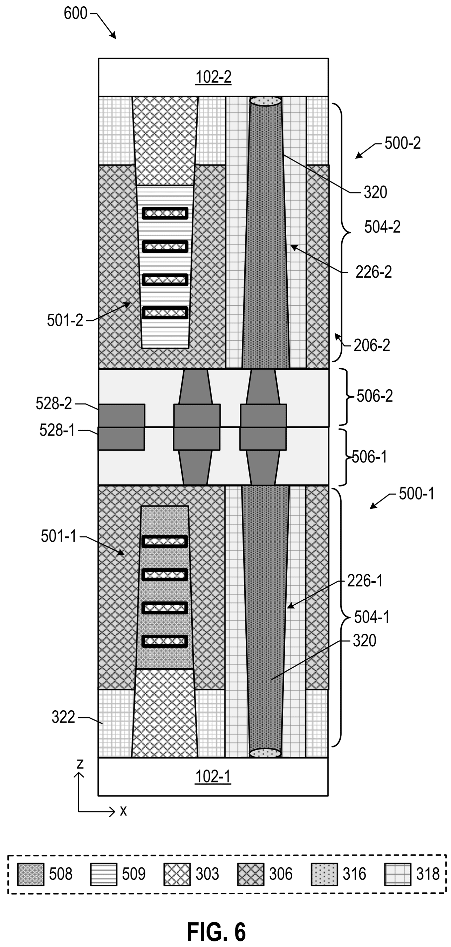

Referring again to FIG. 4, the method 400 continues with a process 404 of bonding the first IC structure 500-1 with the second IC structure 500-2. In an example where the IC structure 500-2 is a wafer, the bonding process involves wafer-to-wafer bonding. In an example where the IC structure 500-2 is a die, the bonding process involves die-to-wafer bonding. The IC structure 600 of FIG. 6 is an example of an IC structure resulting from the process 404. As can be seen in FIG. 6, the IC structure 600 includes the IC structure 500-2 flipped over and bonded with the IC structure 500-1. In the example illustrated in FIG. 6, the IC structures 500-1 and 500-2 are bonded "face-to-face" (e.g., front-side-to-front-side) so that the interconnect layer 506-1 is bonded with the interconnect layer 506-2. In one example, the IC structures 500-1 and 500-2 may be bonded with a hybrid bonding process. For example, the bonding process may be between a layer 506-1 of a first IC structure 500-1 and a layer 506-2 of a second IC structure 500-2 and also between conductive structures within the layers 506-1 and 506-2. In some examples, a bonding interface between the interconnect layer 506-1 and the interconnect layer 506-2 may be present. For example, such a bonding interface may be recognizable as a seam or a thin layer in the resulting IC structure 600 even when the specific materials of the insulators of the lines/vias that are bonded together may be the same. For example, in hybrid bonding, a conductive structure (e.g., a via or line including metal) is exposed through, and flush with, a surface of the layer being bonded. During the bonding process, surfaces of the layers being bonded form a bonding interface layer, including a bonding interface between conductive structures in those layers. Referring to FIG. 6, the conductive line 528-1 of the interconnect layer 506-1 is bonded with the conductive line 528-2 of the interconnect layer 506-2 at the interface between the IC structure 500-1 and the IC structure 500-2.

The conductive structures bonded together via a hybrid bonding process may be conductive lines and/or vias. For example, FIG. 6 illustrates parallel conductive lines (e.g., the conductive lines 528-1 and 528-2) in contact with one another at the bonding interface. In other examples, one layer may include a conductive via in contact with a conductive line at the bonding interface (e.g., a via-to-line connection), or both layers may include conductive vias bonded together at the bonding interface (e.g., a via-to-via connection). In some examples, unintentional practical considerations of the bonding process may result in interconnects that are not perfectly aligned. Accordingly, sections of a combined interconnect structure formed through a hybrid bonding process, which extend through the bonding interface layer, may have some misalignment or offset. Therefore, line-to-line or line-to-via connections may offer greater margin in forming reliable interconnections at the bonding interface compared to via-to-via connections.

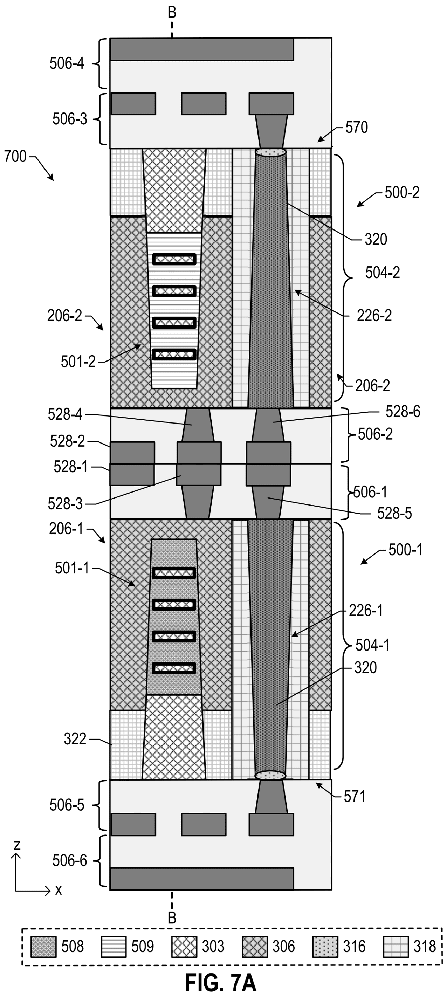

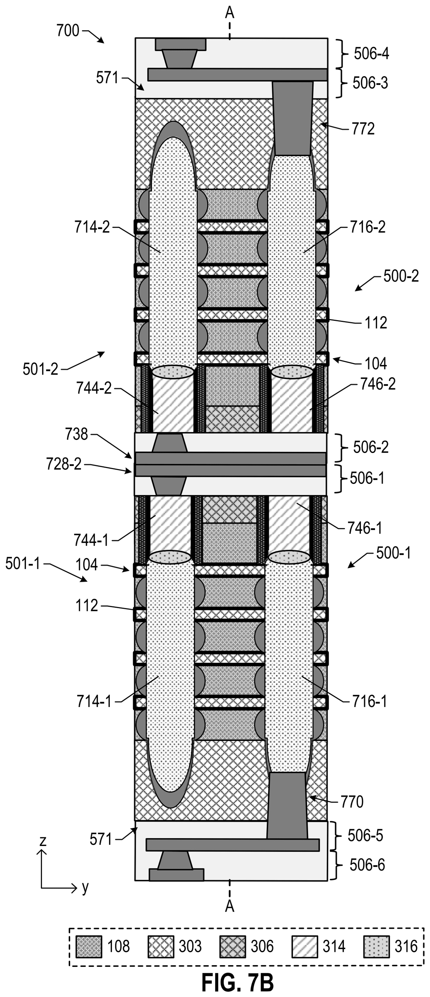

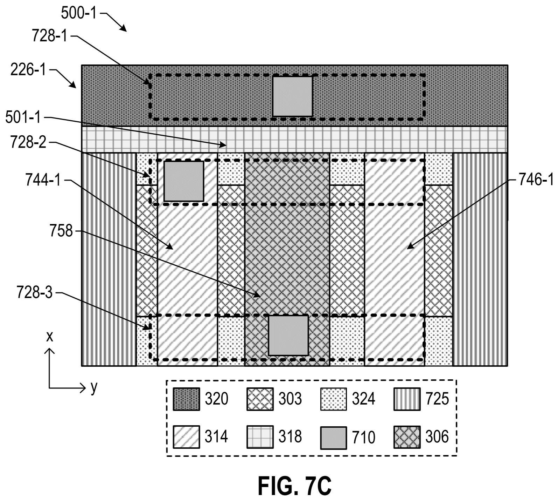

Referring again to FIG. 4, the method 400 continues with a process 406 of providing additional interconnect layers over one or both sides of the stack including the bonded IC structures 500-1 and 500-2. The IC structure 700 of FIGS. 7A-7C is an example of an IC structure resulting from the process 406. FIG. 7A illustrates a cross-section in the x-z plane of the example coordinate system shown in FIG. 1 along a plane AA shown in FIG. 7B. FIG. 7B illustrates a cross-section in the y-z plane of the example coordinate system shown in FIG. 1 along a plane BB shown in FIG. 7A. FIG. 7C illustrates a top-down plan view of one of the IC structure 500-1.

As can be seen in FIG. 7A, the sides 570 and 571 of the bonded wafer stack (e.g., front side and back side of the IC structure 600) have been polished (e.g., to remove the substrate and to reveal conductive contact structures), and metallization stacks have been provided over both the side 570 and the side 571. For example, the IC structure 700 includes interconnect layers 506-3 and 506-4 over the IC structure 500-2 and interconnect layers 506-5 and 506-6 below the IC structure 500-1. The interconnect layers 506-3, 506-4 and 506-5, 506-6 may be provided using techniques for forming frontside and backside interconnects, such as techniques discussed above with respect to the interconnect layers 506-1, 506-2.

FIG. 7B illustrates another cross-sectional view of the IC structure 700. In the view illustrated in FIG. 7B, the S/D regions 714-1, 716-1 of the transistor 501-1 and the S/D regions 714-2, 716-2 of the transistor 501-2 are visible on either side of channel portions of the nanoribbon stacks. The S/D regions 714-1, 716-1 and 714-2, 716-2 may be examples of the S/D regions 114-1, 114-2 discussed above. S/D contacts 744-1 and 746-1 are coupled with the S/D regions 714-1 and 716-1, respectively, of the transistor 501-1. Similarly, the S/D contacts 744-2 and 746-2 are coupled with the S/D regions 714-2 and 716-2, respectively, of the transistor 501-2. In the example illustrated in FIG. 7B, the S/D regions 714-1 and 714-2 may represent drain regions of the transistors 501-1 and 501-2, respectively. As can be seen in FIG. 7B, the drain regions are coupled together via the conductive line 728-2 (also shown in FIG. 7C, discussed below), the conductive line 738.

The S/D regions 716-1 and 716-2 may represent source regions of the transistors 501-1 and 501-2, respectively. In the example illustrated in FIG. 7B, the S/D regions 716-1 and 716-2 are coupled with backside contacts 770 and 772 (e.g., backside source contacts), respectively. In various examples, the S/D regions 716-1 and 716-2 may be coupled with frontside contacts instead of, or in addition to, the backside contacts 770 and 772. (e.g., the S/D region 716-1 may also be coupled with a metal layer via a frontside source contact 746-1). In the example illustrated in FIG. 7B, the transistor 501-2 is over and substantially aligned with the transistor 501-1. In one such example, the drain region 714-2 of the transistor 501-2 is over and substantially aligned with the drain region 714-1 of the transistor 501-1, and the drain regions 714-1, 714-2 may be coupled with the conductive lines 728-2 and vias that are stacked over one another. Similarly, the gate region of the transistor 501-2 may be over the gate region of the transistor 501-1. In this way, the gate regions of the two transistors may be coupled together with a conductive line and via that are stacked over one another. In other examples, the orientation of stacked transistors may be reversed (e.g., the source region of the transistor 501-2 may be over and substantially aligned with drain region of the transistor 501-1, and the drain region of the transistor 501-2 may be over and substantially aligned with the source region of the transistor 501-1).

FIG. 7C illustrates a top-down plan view of an example of the transistor 501-1 of the IC structure 700. The view of FIG. 7C depicts an example of how interconnects may be arranged over the transistor 501-1 in a stacked-transistor CFET arrangement in order to implement an inverter circuit. FIG. 7C depicts a nanoribbon stack of the semiconductor material 303, a drain contact 744-1 of an electrically conductive fill material 314 over and coupled with a drain region 714-1 of a doped semiconductor material 324 (portions of which are shown extending past the sides of the nanoribbon), a source contact 746-1 of the electrically conductive fill material 314 over and coupled with a source region 716-1 of the doped semiconductor material 324 (portions of which are shown extending past the sides of the nanoribbon), and a gate contact 758 of an electrically conductive material 306 over and coupled with a gate stack of the transistor 501-1. Isolation regions 725 may be present between the S/D regions of the transistor 501-1 and adjacent transistors in the same nanoribbon stack.

In the example illustrated in FIG. 7C, the IC structure 500-1 further includes a deep trench via 226-1, which may be coupled with (e.g., configured to be coupled with) a voltage/power rail such as a VDD rail for a P-type transistor and a VSS rail for an N-type transistor. Three conductive lines 728-1, 728-2, 728-3 (shown with dashed-line boxes), which may be in a metal layer/interconnect layer directly over the device region including the transistor 501-1, are shown extending parallel with the nanoribbon of the semiconductor material 303. The conductive line 728-1 is over and substantially aligned with the deep trench via 226-1 and the lines 728-2 and 728-3 are over the S/D contacts 744-1/746-1 and the gate contact 758. Conductive vias 710 are between and coupled with conductive contacts/transistor terminals and the conductive lines 728-1, 728-2, 728-3. For example, a conductive via 710 is between and coupled with the conductive line 728-1 and the deep trench via 226-1, a conductive via 710 is between and coupled with the conductive line 728-2 and a drain contact 744-1, and a conductive via is between and coupled with the conductive line 728-3 and the gate contact 758. The connection of the source contact 746-1 is not specifically shown in FIG. 7C, and in some examples may be coupled with a power rail via the backside of the IC structure. The conductive line 728-1 that is coupled with the deep trench via 226-1 may be coupled with another deep trench via (e.g., the deep trench via 226-2 of the IC structure 500-2) over and substantially aligned with the deep trench via 226-1.

Thus, the IC structure 700 may implement an inverter circuit in which the drain terminals and gate terminals are coupled together via the metal layers between the stacked devices. Other circuits, such as an AND-OR-INVERT (AOI) gate, a multiplexer, etc. may also be achieved with three connections between stacked devices, similar to the configuration shown in FIG. 7C. After forming the interconnect layers 506-3, 506-4 and 506-5, 506-6, the wafer may be diced to form individual dies with the stacked CFET devices formed with hybrid bonding.

Thus, FIG. 4 illustrates a method 400 for fabricating an IC structure with a CFET using hybrid bonding. Performing the method 400 may result in several features in the final IC structure that are characteristic of the use of the method 400. For example, one such feature is illustrated in the IC structure 700 shown in FIG. 7A, in which the IC structure 700 includes a first transistor 501-1 in a first device region 504-1, a second transistor 501-2 in a second device region 504-2, where the second transistor 501-2 is stacked over the first transistor 501-1. The IC structure also includes two or more interconnect layers (e.g., the interconnect layers 506-1 and 506-2) between the first device region 504-1 and the second device region 504-2, where the two or more interconnect layers include a first interconnect layer 506-1 including a first conductive interconnect 528-3 and a second interconnect layer 506-2 including a second conductive interconnect 528-4, and where a first terminal (e.g., gate contact 206-1) of the first transistor 501-1 is coupled with a second terminal (e.g., gate contact 206-2) of the second transistor 501-2 via the first conductive interconnect 528-3 and the second conductive interconnect 528-4. In the example illustrated in FIG. 7A, there are two metal layers between the transistors 501-1 and 501-2 (e.g., M0 of the IC structure 500-1 and M0 of the IC structure 500-2), and the lines or vias coupling the two transistors 501-1 and 501-2 in those layers are in contact. For example, the first conductive interconnect 528-3 is between the first terminal (e.g., gate contact 206-1) and the second conductive interconnect 528-4 and in contact with the second conductive interconnect 528-4, and the second conductive interconnect 528-4 is between the first conductive interconnect 528-3 and the second terminal (e.g., gate contact 206-2) and in contact with the first conductive interconnect 528-3.

Another such feature is depicted in FIG. 7A, which shows deep vias substantially aligned with and coupled together at the bonding interface. For example, the IC structure 700 includes the deep trench via 226-1 extending through the first device region 504-1 and adjacent to the first transistor 501-1 and the deep trench via 226-2 extending through the second device region 504-2 and adjacent to the second transistor 501-2, where the deep trench via 226-2 is over and coupled with the deep trench via 226-1.

Another such feature depicted in FIG. 7A is resulting from the front-side-to-front-side bonding, which in this example results in the conductive interconnects of the interconnect layers 506-1 and 506-2 having opposite taper directions. For example, for certain manufacturing processes, cross-sectional shapes of interconnects in the plane such as that of FIG. 7A may be substantially trapezoidal, i.e., a cross-section of an interconnect may have two parallel sides, one of which is a short side and another one of which is a long side, with the long side being closer to the top face of an IC structure than the short side (i.e., the long side faces the front of the IC structure, while the short side faces the back of the IC structure). For example, dual-Damascene or single-Damascene processes for manufacturing interconnects could result in such trapezoidal cross-sections. This is illustrated in FIG. 7A with the long sides of the trapezoidal cross-sections of the interconnect 528-5 being closer to the front side of the IC structure 500-1, and, therefore, to the bonding interface between the IC structures 500-1 and 500-2, than their short sides. Because in a front-side-to-front-side bonding arrangement, the IC structure 500-2 is flipped over, this means that the long sides of the trapezoidal cross-sections of the interconnects 528-6 are closer to the bonding interface than the short sides, as is shown in FIG. 7A.

Accordingly the resulting IC structure 700 may include stacked transistors, which may in some examples be a CFET device including one N-type and one P-type transistor to enable various CMOS circuits.

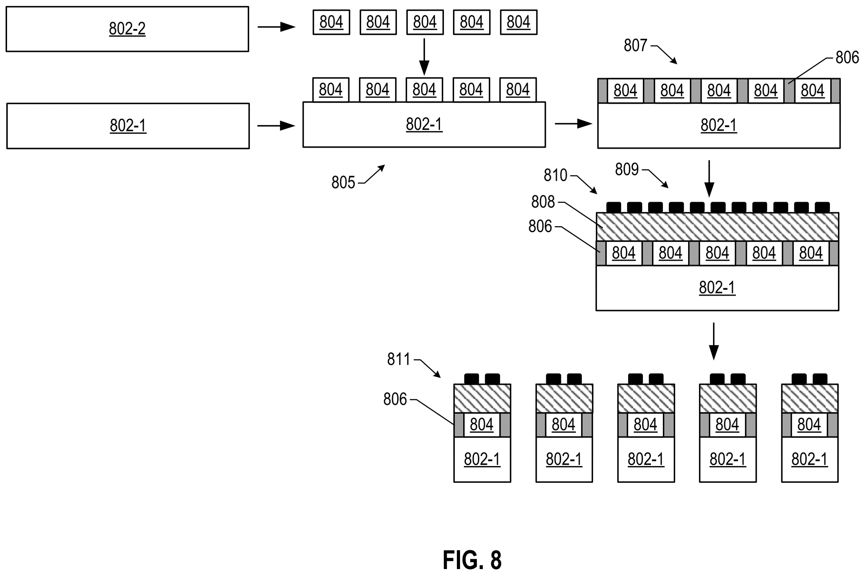

As mentioned briefly above with respect to FIG. 6, in some examples, a process of making an IC structure including CFETs fabricated using hybrid bonding may involve hybrid-bonding dies to a wafer, where one of the dies and wafer include P-type transistors, and the other of the dies and the wafer include N-type transistors. FIG. 8 illustrates a diagram showing a process involving hybrid-bonding dies to a wafer.

The process illustrated in FIG. 8 begins with the independent formation of P-type transistors on one wafer (wafer 802-1 or wafer 802-2) and N-type transistors on the other wafer (wafer 802-1 or wafer 802-2). In this example, wafer 802-2 is thinned and diced into dies 804. These dies are then bonded to wafer 802-1 using a die-to-wafer hybrid bonding process, as shown in IC structure 805. Each die 804 can correspond to the IC structure 500-2 illustrated in FIG. 5. The process continues by surrounding the bonded dies 804 with a reconstitution material, such as silicon oxide or any other suitable insulator material that can withstand the processing temperatures that the structure will be exposed to when forming subsequent interconnect layers. IC structure 807 shows the dies 804 bonded to wafer 802-1 with insulator material 806 (e.g., reconstitution material) between adjacent dies. Next, interconnects, such as a metallization stack 808, are provided over IC structure 807. Conductive bumps 810 are added over the top interconnect layer, as shown in IC structure 809. Finally, IC structure 809 is diced into dies 811, which include CFET structures with stacked N-type and P-type transistors bonded via hybrid bonding. In some examples, insulator material 806 remains in the final dies, while in others, it is removed during dicing.

Accordingly, IC structures including CFETs fabricated using hybrid bonding as described herein offer several benefits. By separately processing NMOS and PMOS devices on different wafers, including at least one interconnect layer, and then hybrid bonding them face-to-face (either wafer-to-wafer or die-to-wafer), the techniques described herein improves yield and performance while reducing costs and time to yield. Additionally, techniques described herein may avoid the complexities of co-integrating NMOS and PMOS on the same wafer, which can enable better optimization of each process. The techniques described herein may also reduce the need for novel interconnections and extensive patterning, further contributing to cost savings and efficiency.

IC structures including CFETs fabricated using hybrid bonding as described herein (e.g., as described with reference to FIGS. 1, 2, 3A-3C, 4, 5, 6, 7A-7C, and 8) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures disclosed herein, e.g., the IC structures 100, 200, and 700, may be included in any suitable electronic component. FIGS. 9-13 illustrate various examples of apparatuses that may include the IC structures 100, 200, and 700 disclosed herein.

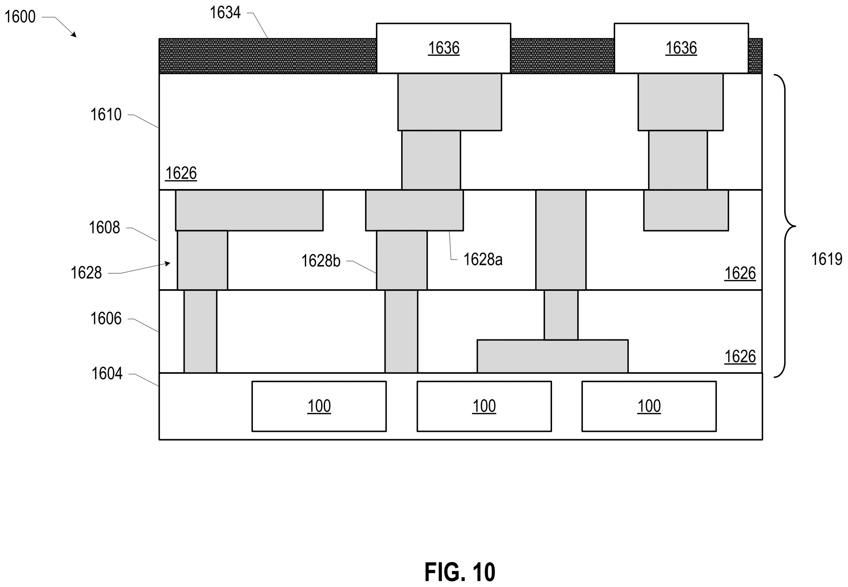

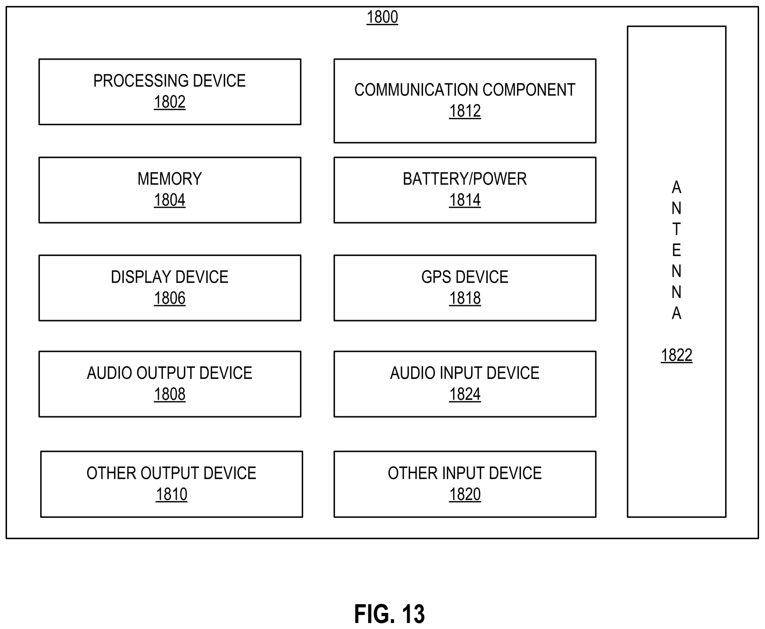

FIG. 9 is a top view of a wafer 1500 and dies 1502 that may include one or more IC structures 100, 200, and 700 in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 100, 200, and 700 (e.g., as discussed below with reference to FIG. 10), one or more transistors (e.g., some of the transistors of the device region 1604 of FIG. 10, discussed below, e.g., nanoribbon-based transistors of the IC structures 100, 200, and 700) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 13) or other logic that is configured to store information in the memory devices or execute instructions stored in the memory array.

FIG. 10 is a side, cross-sectional view of an IC device 1600 that may include one or more IC structures in accordance with any of the embodiments disclosed herein (e.g., in accordance with IC structures 100, 200, and 700). One or more of the IC devices 1600 may be included in one or more dies 1502 (FIG. 9). The IC device 1600 may include a device region 1604 including one or more IC structures (e.g., one or more of IC structures 100, 200, and 700) disclosed herein, or any variations of the IC structures. The device region 1604 may further include electrical contacts to the gates of the transistors included in the device region 1604 and to the S/D materials of the transistors included in the device region 1604 (e.g., to the S/D regions 114-1, 114-2 of the IC structure 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 10 as interconnect layers 1606-1610). For example, electrically conductive features of the device region 1604 (e.g., the gate electrode material 108 of the IC structure 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 10). Although a particular number of interconnect layers 1606-1610 is depicted in FIG. 10, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 10. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 10. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114-1, 114-2 or gate of the IC structure 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 10, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

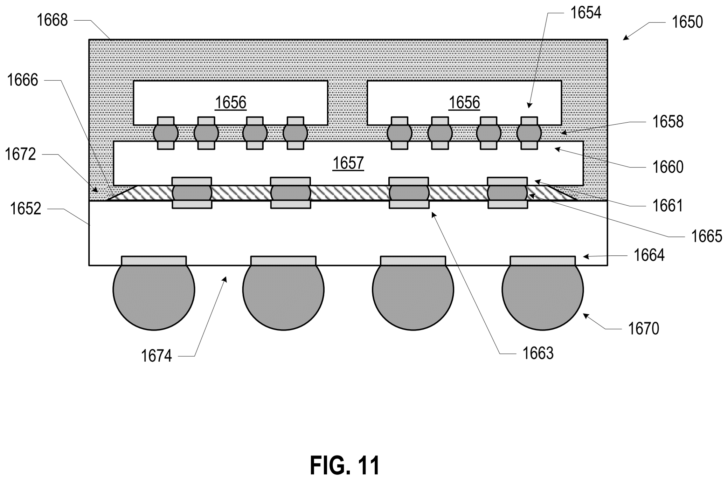

FIG. 11 is a side, cross-sectional view of an example IC package 1650 that may include one or more IC structures 100, 200, and 700 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 10.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 11 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 11 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

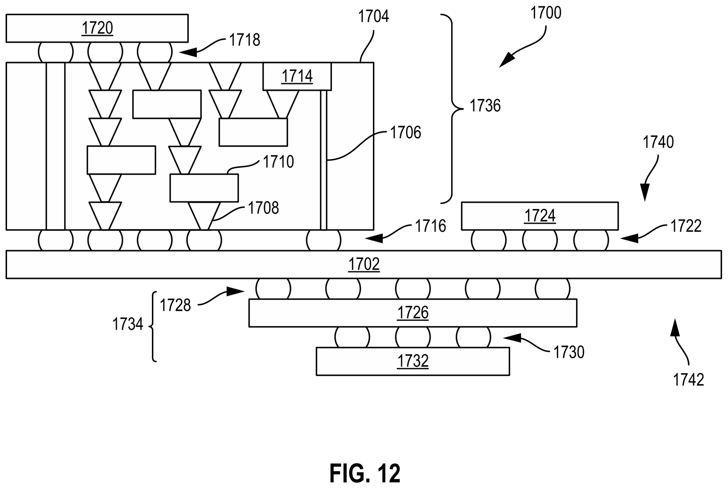

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 11 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 12.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 11 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 11, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 12 is a side, cross-sectional view of an IC device assembly 1700 that may include one or more IC packages or other electronic components (e.g., a die) including one or more IC structures 100, 200, and 700 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 11 (e.g., may include one or more IC structures 100, 200, and 700).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 12 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 12), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 12, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 9), an IC device (e.g., the IC device 1600 of FIG. 10), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 12, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 12 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 13 is a block diagram of an example electrical device 1800 that may include one or more IC structures 100, 200, and 700 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 13 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 13, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a first transistor in a first device region; a second transistor in a second device region, where the second transistor is stacked over the first transistor; and two or more interconnect layers between the first device region and the second device region, where: the two or more interconnect layers include a first interconnect layer including a first conductive interconnect and a second interconnect layer including a second conductive interconnect, and a first terminal of the first transistor is coupled with a second terminal of the second transistor via the first conductive interconnect and the second conductive interconnect.

Example 2 provides the IC structure of example 1, where: the first conductive interconnect is between the first terminal and the second conductive interconnect and in contact with the second conductive interconnect, and the second conductive interconnect is between the first conductive interconnect and the second terminal and in contact with the first conductive interconnect (e.g., there may be two metal layers between the transistors (e.g., M0 and M0), and the lines or vias coupling the two transistors in those layers are in contact).

Example 3 provides the IC structure of example 2, where: the first terminal includes a first drain contact coupled with a first drain region of the first transistor or a first source contact coupled with a first source region of the first transistor, and the second terminal includes a second drain contact coupled with a second drain region of the second transistor or a second source contact coupled with a second source region of the second transistor.

Example 4 provides the IC structure of example 2, where: the first terminal is a first gate contact coupled with a first gate of the first transistor, and the second terminal is a second gate contact coupled with a second gate of the second transistor.

Example 5 provides the IC structure of any one of examples 1-4, where: the first conductive interconnect includes a conductive line in a plane that is substantially orthogonal to the first device region and that intersects a source region and a drain region of the first transistor.

Example 6 provides the IC structure of example 5, where the conductive line is a first conductive line, and where: the second conductive interconnect includes a second conductive line parallel with and in contact with the first conductive line (e.g., a line-to-line connection at the interface).

Example 7 provides the IC structure of example 5, where: the second conductive interconnect includes a conductive via in contact with the conductive line (e.g., a line-to-via connection at the interface).

Example 8 provides the IC structure of any one of examples 1-4, where: the first conductive interconnect includes a first conductive via, and the second conductive interconnect includes a second conductive via in contact with the first conductive via (e.g., a via-to-via connection at the interface).

Example 9 provides the IC structure of any one of examples 1-3 and 5-8, where: the first transistor includes a first source region and a first drain region, the second transistor includes a second source region and a second drain region, the second drain region is over and substantially aligned with the first source region, the second source region is over and substantially aligned with the first drain region, the first terminal is coupled with the first drain region, and the second terminal is coupled with the second drain region (e.g., the drain regions are coupled together but the orientation of the transistors is flipped so that the drain regions are not directly stacked over one another).

Example 10 provides the IC structure of any one of examples 1-9, further including a first conductive via through the first device region and adjacent to the first transistor; and a second conductive via through the second device region and adjacent to the second transistor, where the second conductive via is over (e.g., and substantially aligned with) and coupled with the first conductive via.

Example 11 provides the IC structure of example 1, where: the two or more interconnect layers include a first metallization stack including one to six first interconnect layers, and a second metallization stack between the first metallization stack and the second device region, where the second metallization stack includes one to six second interconnect layers, and an individual one of the first conductive interconnects of the first metallization stack has an opposite taper direction relative to an individual one of the second conductive interconnects.

Example 12 provides the IC structure of any one of examples 1-11, where: the first transistor includes a first region that is either a first source region or a first drain region of the first transistor, the second transistor includes a second region that is either a second source region or a second drain region of the second transistor, and one of the first region and the second region includes P-type dopants and another of the first region and the second region includes N-type dopants (e.g., one transistor is an NMOS transistor and another is a PMOS transistor).

Example 13 provides the IC structure of any one of examples 1-11, where: the first transistor includes a first channel region with a first width, the second transistor includes a second channel region with a second width, and the first width is different from the second width (e.g., the stacked transistors may have different channel widths).

Example 14 provides the IC structure of any one of examples 1-13, where: the first transistor includes a first channel region including a first channel material, the second transistor includes a second channel region including a second channel material, and the first channel material is different from the second channel material (e.g., Si and GaN or Si and 2D/TMD material, etc.).

Example 15 provides the IC structure of any one of examples 1-14, where: the first transistor includes a first channel region including a first channel material, the second transistor includes a second channel region including a second channel material, and the first channel material has a different crystal orientation relative to the second channel material.

Example 16 provides the IC structure of any one of examples 1-15, where: the first transistor includes a first channel region and a first gate structure coupled with the first channel region, the second transistor includes a second channel region and a second gate structure coupled with the second channel region, and in a cross-section in a plane substantially orthogonal to the first device region and through the first channel region and a first source or drain region of the first transistor: the first gate structure has different geometry from the second gate structure (e.g., the transistors may have different architectures, e.g., ribbonFET and spineFET, ribbonFET and finFET, spineFET and finFET, etc.).

Example 17 provides the IC structure of any one of examples 1-16, further including a first metallization stack (e.g., "backside" metal layers formed after wafer-to-wafer bonding) below a first side of the first device region opposite the two or more interconnect layers; and a second metallization stack (e.g., "frontside" metal layers formed after wafer-to-wafer bonding) over a second side of the second device region opposite the two or more interconnect layers.

Example 18 provides the IC structure of any one of examples 1-17, where the IC structure includes an IC die, and where the IC structure further includes an insulator material (e.g., reconstitution material) around sides of the IC die.

Example 19 provides the IC structure of any one of examples 1-18, further including a bonding interface between the first conductive interconnect and the second conductive interconnect.

Example 20 provides an IC structure, including a first transistor in a first front end of line (FEOL) layer; a first conductive via through the first FEOL layer and adjacent to the first transistor; a second transistor in a second FEOL layer, where the second transistor is over the first transistor; a second conductive via through the second FEOL layer and adjacent to the second transistor; and two or more interconnect layers between the first transistor and the second transistor, where: a first terminal of the first transistor is coupled with a second terminal of the second transistor with a first conductive interconnect of the two or more interconnect layers, and the first conductive via is coupled with the second conductive via with a second conductive interconnect of the two or more interconnect layers.

Example 21 provides the IC structure of example 20, where: the two or more interconnect layers include a first interconnect layer including the first conductive interconnect, and a second interconnect layer including another conductive interconnect between and in contact with the first conductive interconnect and the second terminal.

Example 22 provides an IC structure according to any one of examples 1-21, where the IC structure includes or is a part of a central processing unit.

Example 23 provides an IC structure according to any one of examples 1-22, where the IC structure includes or is a part of a memory device.

Example 24 provides an IC structure according to any one of examples 1-23, where the IC structure includes or is a part of a logic circuit.

Example 25 provides an IC structure according to any one of examples 1-24, where the IC structure includes or is a part of input/output circuitry.

Example 26 provides an IC structure according to any one of examples 1-25, where the IC structure includes or is a part of a field programmable gate array transceiver.

Example 27 provides an IC structure according to any one of examples 1-26, where the IC structure includes or is a part of a field programmable gate array logic.

Example 28 provides an IC structure according to any one of examples 1-27, where the IC structure includes or is a part of a power delivery circuitry.

Example 29 provides an IC package that includes an IC die including an IC structure according to any one of examples 1-28; and a further IC component, coupled to the IC die.

Example 30 provides an IC package according to example 29 where the further IC component includes a package substrate.

Example 31 provides an IC package according to example 29, where the further IC component includes an interposer.

Example 32 provides an IC package according to example 29, where the further IC component includes a further IC die.

Example 33 provides a computing device that includes a carrier substrate and an IC structure coupled to the carrier substrate, where the IC structure is an IC structure according to any one of examples 1-28, or the IC structure is included in the IC package according to any one of examples 29-32.

Example 34 provides a computing device according to example 33, where the computing device is a wearable or handheld computing device.

Example 35 provides a computing device according to examples 33 or 34, where the computing device further includes one or more communication chips.

Example 36 provides a computing device according to any one of examples 33-35, where the computing device further includes an antenna.

Example 37 provides a computing device according to any one of examples 33-36, where the carrier substrate is a motherboard.

Example 38 provides a process of making an IC structure, the process including providing a first IC structure including a first device region and a first interconnect layer over a first side of the first device region, where the first interconnect layer includes a first conductive interconnect coupled with a first terminal of a first transistor of the first device region; providing a second IC structure including a second device region and a second interconnect layer over a second side of the second device region, where the second interconnect layer includes a second conductive interconnect coupled with a second terminal of a second transistor of the second device region; bonding the first side of the first IC structure with the second side of the second IC structure, including bonding the first conductive interconnect of the first interconnect layer with the second conductive interconnect of the second interconnect layer; providing a metallization stack (e.g., frontside metal layers) over a side of the second device region opposite the second side; and dicing a structure including the first IC structure, the second IC structure, and the metallization stack.

Example 39 provides the process of example 38, further including providing a second metallization stack (e.g., backside metal layers) over another side of the first device region opposite the first side.

Example 40 provides the process of any one of examples 38-39, where: providing the first IC structure includes providing a first wafer including the first device region and the first interconnect layer, and providing the second IC structure includes providing a second wafer including the second device region and the second interconnect layer.

Example 41 provides the process of any one of examples 38-40, where: providing the first IC structure includes providing a first wafer including the first device region and the first interconnect layer, and providing the second IC structure includes providing a die including the second device region and the second interconnect layer.

Example 42 provides the process of example 41, further including after the bonding, providing an insulator material over and around the second IC structure; and removing the insulator material from over a top of the second IC structure prior to providing the metallization stack.

Example 43 provides a process according to any one of examples 38-42, where the IC structure is an IC structure according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a first transistor in a first device region;
a second transistor in a second device region, wherein the second transistor is stacked over the first transistor; and
two or more interconnect layers between the first device region and the second device region, wherein:
the two or more interconnect layers comprise a first interconnect layer comprising a first conductive interconnect and a second interconnect layer comprising a second conductive interconnect, and
a first terminal of the first transistor is coupled with a second terminal of the second transistor via the first conductive interconnect and the second conductive interconnect.

2. The IC structure of claim 1, wherein:
the first conductive interconnect is between the first terminal and the second conductive interconnect and in contact with the second conductive interconnect, and
the second conductive interconnect is between the first conductive interconnect and the second terminal and in contact with the first conductive.

3. The IC structure of claim 2, wherein:
the first terminal comprises a first drain contact coupled with a first drain region of the first transistor or a first source contact coupled with a first source region of the first transistor, and
the second terminal comprises a second drain contact coupled with a second drain region of the second transistor or a second source contact coupled with a second source region of the second transistor.

4. The IC structure of claim 2, wherein:
the first terminal is a first gate contact coupled with a first gate of the first transistor, and
the second terminal is a second gate contact coupled with a second gate of the second transistor.

5. The IC structure of any one of claims 1-4, wherein:
the first conductive interconnect comprises a conductive line in a plane that is substantially orthogonal to the first device region and that intersects a source region and a drain region of the first transistor.

6. The IC structure of claim 5, wherein the conductive line is a first conductive line, and wherein:
the second conductive interconnect comprises a second conductive line parallel with and in contact with the first conductive line.

7. The IC structure of claim 5 or 6, wherein:
the second conductive interconnect comprises a conductive via in contact with the conductive line.

8. The IC structure of any one of claims 1-7, wherein:
the first conductive interconnect comprises a first conductive via, and
the second conductive interconnect comprises a second conductive via in contact with the first conductive via.

9. The IC structure of any one of claims 1-8, wherein:
the first transistor comprises a first source region and a first drain region,
the second transistor comprises a second source region and a second drain region,
the second drain region is over and substantially aligned with the first source region,
the second source region is over and substantially aligned with the first drain region,
the first terminal is coupled with the first drain region, and
the second terminal is coupled with the second drain region.

10. The IC structure of any one of claims 1-9, further comprising:
a first conductive via through the first device region and adjacent to the first transistor; and
a second conductive via through the second device region and adjacent to the second transistor, wherein the second conductive via is over and coupled with the first conductive via.

11. The IC structure of any one of claims 1-10, wherein:
the two or more interconnect layers comprise:
a first metallization stack comprising one to six first interconnect layers, and
a second metallization stack between the first metallization stack and the second device region, wherein the second metallization stack comprises one to six second interconnect layers, and
an individual one of the first conductive interconnects of the first metallization stack has an opposite taper direction relative to an individual one of the second conductive interconnects.

12. The IC structure of any one of claims 1-11, wherein:
the first transistor comprises a first region that is either a first source region or a first drain region of the first transistor,
the second transistor comprises a second region that is either a second source region or a second drain region of the second transistor, and
one of the first region and the second region comprises P-type dopants and another of the first region and the second region comprises N-type.

13. The IC structure of any one of claims 1-12, wherein:
the first transistor comprises a first channel region with a first width,
the second transistor comprises a second channel region with a second width, and
the first width is different from the second width.

14. The IC structure of any one of claims 1-13, wherein:
the first transistor comprises a first channel region comprising a first channel material,
the second transistor comprises a second channel region comprising a second channel material, and
the first channel material is different from the second channel material.

15. The IC structure of any one of claims 1-14, wherein:
the first transistor comprises a first channel region comprising a first channel material,
the second transistor comprises a second channel region comprising a second channel material, and
the first channel material has a different crystal orientation relative to the second channel material.
